# FASCICULE DE BREVET EUROPEEN

(11) **EP 2 145 857 B1**
(45) Date de publication et mention de la délivrance du brevet: **19.03.2014**
(21) Numéro de dépôt: 08160143.7
(22) Date de dépôt: 10.07.2008
(51) Int. Cl.: B81C 99/00, B81C 3/00, G04B 13/02, G04D 3/00

(54) **Procédé de fabrication d'une pièce micromécanique**
Verfahren zur Herstellung eines mikromechanischen Bauteils
Method of manufacturing a micromechanical part

(43) Date de publication de la demande: 20.01.2010
(73) Titulaire: The Swatch Group Research and Development Ltd., 2074 Marin (CH)
(72) Inventeur: Dinger, Rudolf, 2024, Saint-Aubin (CH); Ravenel, Thierry, 2068, Hauterive (FR)
(74) Mandataire: Couillard, Yann Luc Raymond

(56) Documents cités:
- PERRET A: "Le Silicium Comme Matériau Dans La Fabrication De Pièces Mécaniques" BULLETIN DE LA SOCIETE SUISSE DE CHRONOMETRIE, SSC, NEUCHATEL, CH, no. 38, 9 novembre 2001 (2001-11-09), pages 27-29, XP002460036
- DATABASE WPI Week 199918 Thomson Scientific, London, GB; AN 1999-209545 XP002512880 -& JP 11 048342 A (SUMITOMO HEAVY IND LTD) 23 février 1999 (1999-02-23)

## Description

### Domaine de l'invention

L'invention se rapporte à un procédé de fabrication d'une pièce mécanique réalisée à base d'un matériau micro-usinable et, plus particulièrement, une telle pièce destinée à être utilisée pour la fabrication d'une pièce d'horlogerie.

### Arrière plan de l'invention

Il est connu de fabriquer une partie d'une pièce d'horlogerie en matériau à base de silicium cristallin. Un exemple d'un tel procédé est décrit dans le document "Le Silicium Comme Matériau Dans La Fabrication De Pièces Mécaniques" de André Perret, BULLETIN DE LA SOCIETE SUISSE DE CHRONOMETRIE, no. 38, 9 novembre 2001, pages 27-29. En effet, l'utilisation d'un matériau micro-usinable comme le silicium cristallin présente des avantages en terme de précision de fabrication grâce aux avancées des procédés actuels notamment dans le domaine de l'électronique. Ainsi, s'il apparaît possible de fabriquer des spiraux, il n'est pas encore possible d'appliquer les matériaux micro-usinables à toutes les parties d'une pièce d'horlogerie du fait de leurs caractéristiques tribologiques insuffisantes. De plus, les procédés actuels de fabrication restent complexes à mettre en oeuvre et imposent la manipulation directe des pièces fabriquées au risque de les détériorer.

### Résumé de l'invention

Le but de la présente invention est de pallier tout ou partie les inconvénients cités précédemment en proposant un procédé qui autorise, de manière simple, un assemblage préalable fiable de la pièce en évitant toute manipulation de ses parties fonctionnelles afin que la pièce soit prête à être montée dans un dispositif tel qu'une pièce d'horlogerie sans avoir à la toucher. De plus, le procédé permet la fabrication de qualité d'une pièce micromécanique pouvant être appliquée à la plupart des parties mécaniques horlogères.

A cet effet, l'invention se rapporte à un procédé de fabrication d'une pièce mécanique comportant les étapes suivantes :
a) se munir d'un substrat en un matériau micro-usinable ;
b) graver par photolithographie, dans la totalité de l'épaisseur dudit substrat, un motif comportant ladite pièce ;
   **caractérisé en ce qu**'il comporte en outre les étapes suivantes :
c) assembler une attache sur ladite pièce afin que cette dernière soit prête à être montée sans avoir à toucher la partie en matériau micro-usinable.
d) libérer la pièce du substrat afin de la monter dans un dispositif comme un mouvement de pièce d'horlogerie.

Conformément à d'autres caractéristiques avantageuses de l'invention :
- l'étape c) comporte les étapes : e) monter sur un support munis de fourchettes ledit substrat afin que les fourchettes coopèrent avec ladite pièce et f) assembler l'attache sur la pièce montée contre le support;
- l'étape e) comporte les étapes : g) guider le substrat par rapport audit support à l'aide de moyens d'alignement afin d'orienter fiablement ledit substrat et h) glisser le substrat et la pièce contre respectivement au moins un axe et les fourchettes solidaires du support jusqu'à buter contre un épaulement respectivement dudit au moins un axe et desdites fourchettes afin de préparer le montage de l'attache ;
- les moyens d'alignement sont situés plus haut que ledit au moins un axe et lesdites fourchettes afin de garantir la consécutivité des étapes g) puis h) ;
- le support comporte plusieurs moyens d'alignement afin d'améliorer le guidage de l'étape g) ;
- le procédé comprend, en outre, entre les étapes b) et c), les étapes : i) monter sur une base ledit substrat gravé afin de laisser accessibles les faces supérieure et inférieure de ce dernier et j) déposer un revêtement sur la surface extérieure de ladite pièce de meilleure qualité tribologique que ledit matériau micro-usinable ;
- l'étape h) comporte les étapes : k) guider le substrat par rapport à ladite base à l'aide de moyens d'alignement afin d'orienter fiablement ledit substrat et I) glisser le substrat contre au moins un axe solidaire du support jusqu'à buter contre un épaulement dudit au moins un axe réalisé à distance dudit support afin de maintenir en hauteur le substrat par rapport audit support ;
- les moyens d'alignement sont situés plus haut que ledit au moins un axe afin de garantir la consécutivité des étapes k) puis I) ;
- le support comporte plusieurs moyens d'alignement afin d'améliorer le guidage de l'étape k) ;
- lors de l'étape b), au moins un pont de matière est gravé dans le motif afin de maintenir solidaire la pièce avec le substrat ;
- ledit au moins un pont de matière comporte une section rétrécie à l'extrémité reliée au motif de ladite pièce permettant de créer une zone de faiblesse apte à faciliter l'étape e) ;
- l'étape d) est réalisée par déplacement relatif entre la pièce et le substrat afin de casser ledit au moins un pont de matière ;
- plusieurs pièces sont fabriquées à partir du même substrat ;
- ledit matériau micro-usinable étant choisi parmi le groupe comprenant du silicium cristallin, de la silice cristalline et de l'alumine cristalline.

### Description sommaire des dessins

D'autres particularités et avantages ressortiront clairement de la description qui en est faite ci-après, à titre indicatif et nullement limitatif, en référence aux dessins annexés, dans lesquels :
- la figure 1 est une représentation d'un substrat après une étape de photolithographie ;
- la figure 2 est un agrandissement d'une partie de la figure 1 ;
- la figure 3 est une représentation d'une étape de montage sur une base selon l'invention ;
- la figure 4 est une représentation d'une étape de dépôt d'un revêtement ;
- la figure 5 est une représentation d'une étape de montage sur un support selon l'invention ;
- la figure 6 est une représentation d'une étape d'assemblage d'une attache selon l'invention ;
- la figure 7 est un schéma fonctionnel du procédé de l'invention.

### Description détaillée des modes de réalisation préférés

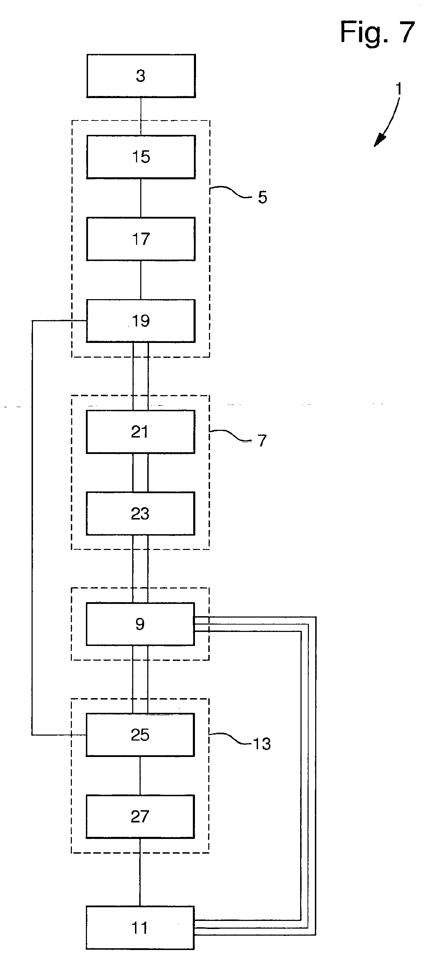

Dans l'exemple illustré à la figure 7, on peut voir le schéma fonctionnel d'un procédé généralement annoté 1. Le procédé 1 comporte principalement six étapes 3, 5, 7, 9, 11 et 13 destinées à fabriquer une pièce mécanique 51 dont l'âme est réalisée à base d'un matériau micro-usinable. En effet, un matériau micro-usinable, grâce à ses précisions inférieures au micromètre, est particulièrement utile pour la fabrication d'un élément, par exemple, d'une pièce d'horlogerie et remplace avantageusement un matériau métallique utilisé habituellement.

Dans l'explication ci-après, le matériau micro-usinable peut être à base de silicium cristallin comme, par exemple, du silicium monocristallin, de la silice cristalline comme du quartz ou encore de l'alumine cristalline comme du corindon (également appelé saphir synthétique). Evidemment, d'autres matériaux micro-usinables peuvent être envisagés.

L'étape 3 consiste à se munir d'un substrat 53 en matériau micro-usinable comme, par exemple, une plaquette en silicium monocristallin utilisée pour la fabrication de composants électroniques (également appelé « wafer » en anglais). Préférentiellement, une phase d'amincissement est prévue lors de l'étape 3 afin d'adapter l'épaisseur finale de la pièce 51. Une telle phase peut être réalisé par un procédé de rodage mécanique ou chimique (également connu sous les termes anglais « back lapping »).

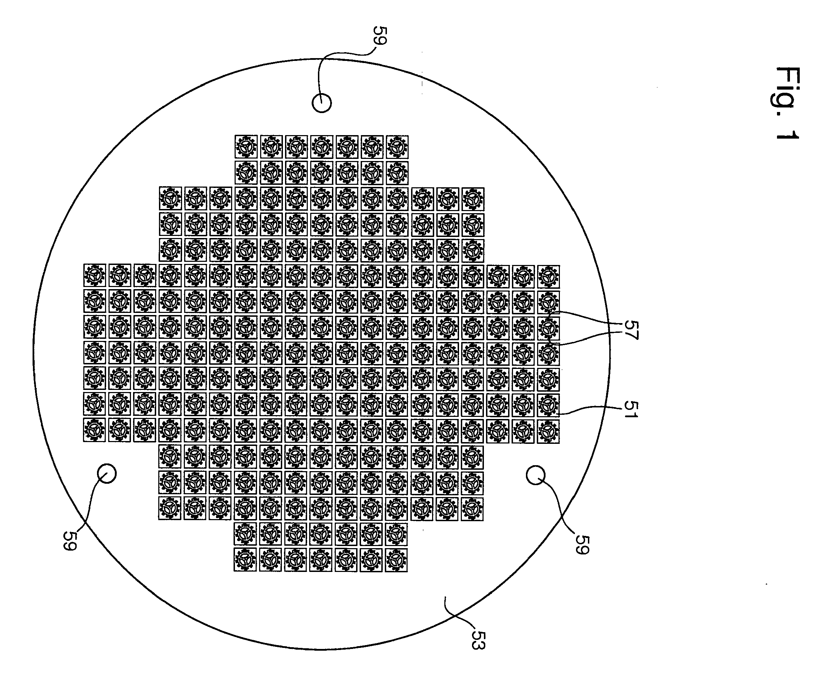

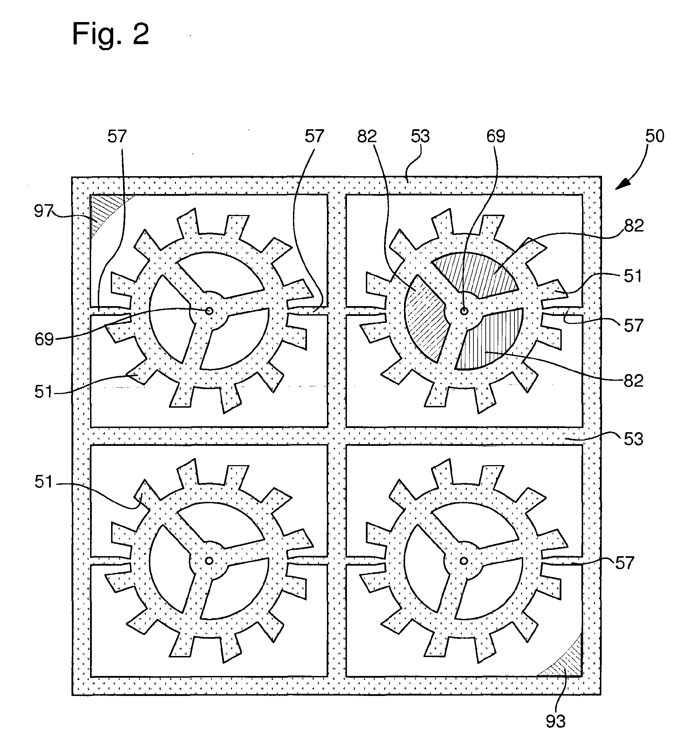

L'étape 5 consiste à réaliser par photolithographie, dans la totalité de l'épaisseur du substrat 53, un motif 50 comportant la pièce mécanique 51 à fabriquer. Avantageusement, comme visible aux figures 1 et 2, la taille, plus grande, du substrat 53 par rapport à celle de la pièce 51 autorise la gravure de plusieurs motifs 50 et donc la fabrication de plusieurs pièces 51 à partir du même substrat 53.

Dans l'exemple illustré aux figures 1 et 2, chaque pièce mécanique 51 est une roue d'échappement pour une pièce d'horlogerie. Bien évidemment, la procédé 1 permet de fabriquer d'autres parties d'une pièce d'horlogerie mais également, comme expliqué ci-après, plusieurs parties différentes sur un même substrat 53.

L'étape 7 consiste à monter sur une base 55 le substrat 53 gravé afin de laisser accessibles ses faces supérieure et inférieure. Cette étape permet de faciliter la mise en oeuvre de l'étape 9 consistant à déposer un revêtement sur la surface extérieure de la pièce 51 de meilleure qualité tribologique que ledit matériau micro-usinable. En effet, la mise en hauteur du substrat 53 par rapport à la base 55 permet de faciliter le dépôt du revêtement en ce qu'elle facilite l'accessibilité aussi bien sur le dessus, sur l'épaisseur et sur le dessous de chaque pièce 51.

L'étape 9 permet de déposer un revêtement qui remplace avantageusement des qualités tribologiques insuffisantes éventuelles du matériau micro-usinable.

Un tel revêtement peut être, par exemple, à base d'un allotrope de carbone. II peut ainsi être envisagé de déposer un revêtement de carbone cristallin comme du diamant synthétique par dépôt chimique en phase vapeur (également connu sous l'abréviation anglaise « CVD »). II peut également être déposé du carbone amorphe comme du carbone sous forme diamant (également connu sous l'abréviation anglaise « DLC » venant des termes « Diamond-Like-Carbon ») par dépôt physique en phase vapeur (également connu sous l'abréviation anglaise « PVD »). Bien entendu, un ou plusieurs autres matériaux peuvent être utilisés en remplaçant ou en adjuvant du carbone. D'autres procédés de dépôt sont également envisageables.

L'étape 13 consiste à assembler une attache 91 sur la pièce 51 à l'aide d'un support 81 afin que la pièce 51 préassemblée soit prête à être montée sans avoir à toucher la partie en matériau micro-usinable.

L'étape 11 consiste à libérer chaque pièce 51 du substrat 53. Ainsi, dans l'exemple illustré aux figures, on peut obtenir sur un même substrat 53, selon le procédé 1, plusieurs dizaines de pièces mécaniques 51. Dans l'exemple illustré aux figures 1 à 6, on peut ainsi obtenir, par exemple, des roues d'échappement dont l'âme est en silicium monocristallin et, suivant les modes de réalisation expliqués ci-après, comportant une surface externe en diamant synthétique et/ou une attache 91 préassemblée.

A partir des étapes principales 3, 5, 7, 9, 11 et 13, il va maintenant être expliqué chacun des modes de réalisation. Dans un premier mode de réalisation, le procédé 1 comporte les étapes consécutives 3, 5, 13 et 11 comme illustré par un trait simple à la figure 7. La première étape 3 consiste à se munir d'un substrat 53 en matériau micro-usinable.

Puis la deuxième étape 5 consiste à réaliser par photolithographie, dans la totalité de l'épaisseur du substrat 53, les motifs 50 comportant chacun une pièce mécanique 51 à fabriquer. Selon le premier mode de réalisation illustré dans le schéma fonctionnel de la figure 7, la deuxième étape 5 comporte trois phases 15, 17 et 19.

Dans une première phase 15, un masque de protection est structuré sur le substrat 53. Préférentiellement, le masque de protection est réalisé à l'aide d'une résine photosensible. Le masque de protection est ainsi formé à l'aide d'un rayonnement sélectif permettant de structurer ledit masque de forme correspondante à chaque motif 50 à réaliser. Grâce à cette étape 15, il sera possible de manière très précise de graver n'importe quelle forme plane de manière sélective sur le substrat 53.

Dans une deuxième phase 17, une attaque par gravure anisotropique de l'ensemble substrat 53 - masque de protection est effectuée. Préférentiellement, une attaque du type gravure ionique réactive profonde est utilisée (également connu sous l'abréviation anglaise « DRIE »). L'attaque anisotropique permet de graver se manière sensiblement rectiligne le substrat 53 au niveau des zones non protégées par ledit masque de protection. Préférentiellement, la gravure lors de la deuxième phase 17 est réalisée sur toute l'épaisseur du substrat 53 et, éventuellement, selon un axe cristallographique du matériau micro-usinable favorable à cette attaque.

De plus de manière préférée selon l'invention, chaque motif 50, comme illustré aux figures 1 et 2, comporte deux ponts de matière 57. Ces derniers autorisent le maintien de la pièce 51 par rapport au substrat 53 jusqu'à l'étape 11. Comme visible à la figure 2, les ponts de matière 57 comportent une section rétrécie à l'extrémité reliée au motif de la pièce 51 permettant de créer une zone de faiblesse apte à faciliter l'étape 11 de libération.

Enfin, selon le premier mode de réalisation, la deuxième phase 17 est également utilisée pour graver dans le substrat 53 des trous 59 formant une partie des moyens d'alignement. Dans l'exemple illustré à la figure 1, on peut voir qu'il a été formé trois trous 59 distribués sensiblement à 120 degrés les uns des autres et à proximité des extrémités du substrat 53.

Dans une troisième et dernière phase 19 de la deuxième étape 5, le masque de protection est retiré de la surface du substrat 53. On obtient alors un substrat 53 comportant plusieurs motifs 50 comprenant une pièce 51 solidaire du substrat 53 par deux ponts de matière 57 comme illustré aux figures 1 et 2. Bien entendu, lors de l'étape 5, il peut être envisagé de réaliser un seul ou plus de deux ponts de matière 57.

Selon le premier mode de réalisation, la troisième étape 13 consiste à assembler une attache 91 sur la pièce 51 à l'aide d'un support 81 afin que la pièce 51 préassemblée soit prête à être montée sans avoir à toucher la partie en matériau micro-usinable. L'étape 13 comporte les phases 25 et 27.

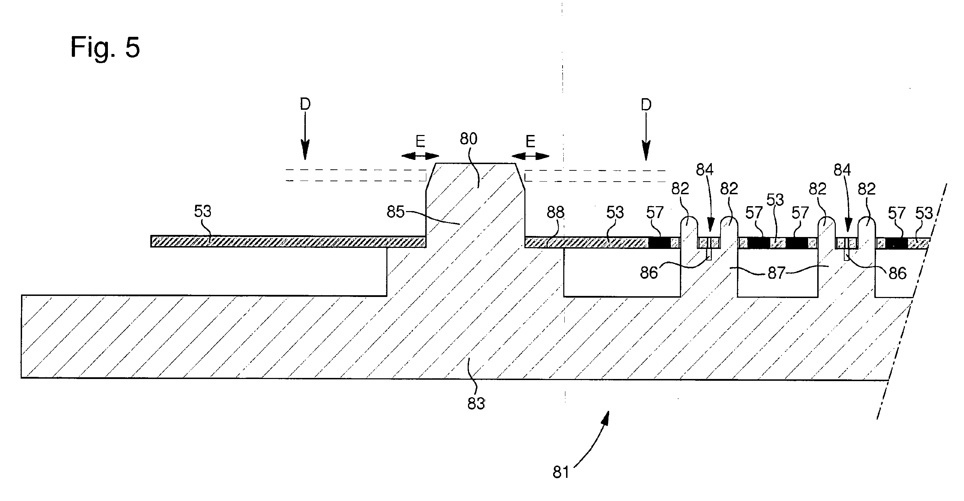

La première phase 25 consiste à monter sur un support 81, muni de fourchettes 87, le substrat 53 afin que des dents 82 d'une fourchette 87 coopèrent avec chaque pièce 51 et ainsi facilite le montage de l'attache 91. Comme visible à la figure 5, dans un premier temps par rapprochement selon la direction D du substrat 53 par rapport au support 81, le substrat 53 est guidé selon les directions E à l'aide de moyens d'alignement afin d'orienter fiablement le substrat 53 par rapport au support 81.

Préférentiellement, les moyens d'alignements sont formés par une colonne chanfreinée 80, montée en prolongement d'un axe 85 solidaire sensiblement perpendiculairement du support 81, qui coopère avec un des évidements 59 réalisés dans le substrat 53 lors de l'étape 5. De manière préférée, le procédé 1 comporte trois moyens d'alignement 80, 59afin d'améliorer le guidage de la première phase 25.

Dans un deuxième et dernier temps, en continuant le rapprochement selon la translation D du substrat 53 par rapport au support 81, le substrat 53 puis chaque pièce 51 glissent contre respectivement chaque axe 85 et chaque fourchette 87 tous solidaires du support 81. Le deuxième temps s'achève lorsque le substrat 53 et chaque pièce 51 butent sensiblement contre respectivement l'épaulement 88 de chaque axe 85 et l'épaulement de chaque fourchette 87 formé dans le fond de l'espace 84 que ses dents délimitent.

Comme visible à la figure 5 à la fin de la phase 25, le substrat 53 et chaque pièce 51 (encore solidaire du substrat 53) sont posés de manière stables et ont comme degré de liberté unique la translation D vers le haut. Dans l'exemple illustré sur le motif en haut à droite de la figure 2, on peut voir trois dents 82 d'une fourchette 87 dont la forme correspond chacune à l'interstice libre entre deux bras de la roue d'échappement 51. Bien entendu, suivant la pièce 51 fabriquée, les fourchettes 87 seront adaptées. Préférentiellement, le support 81 est formé à partir d'un matériau qui ne blesse pas la pièce 51 comme, par exemple, un polymère plastique.

De manière préférée, les moyens d'alignement 80, 59 sont situés plus haut verticalement que les axes 85 et les fourchettes 87 afin de garantir la consécutivité du premier temps puis du deuxième temps.

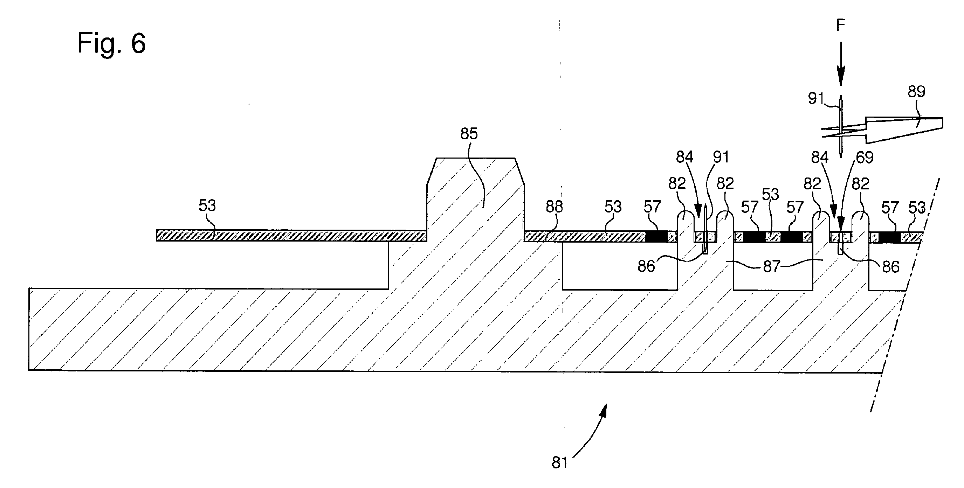

Dans la deuxième phase 27 de la troisième étape 13, une attache 91 est assemblée sur chaque pièce 51. Dans l'exemple illustré à la figure 6, on peut voir une première pièce 51 assemblée et une deuxième pièce 51 plus à droite dont l'attache 91 n'est pas encore assemblée. Bien entendu, cette figure 6 est utilisée pour une meilleure compréhension. En effet, le montage des attaches 91 ne saurait se limiter à un assemblage un à un à l'aide de brucelles 89 mais peut bien évidemment être réalisé en même temps pour chaque pièce 51 à l'aide d'un automate.

Comme visible sur la pièce 51 de droite non assemblée, dans un premier temps, l'attache 91 est déplacée selon la translation F vers le centre percé 69 de la pièce 51 contenu dans l'espace 84 délimité par les dents 82. Préférentiellement, la translation maximale de l'attache 91 par rapport au centre 69 est délimitée par la hauteur du trou 86 réalisé en prolongement de l'espace 84 ce qui permet de monter fiablement l'attache 91 par rapport à la pièce 51.

Dans un deuxième temps, une fois toutes les attaches 91 mises sur toutes les pièces 51, on solidarise définitivement l'attache 91 et la pièce 51, par exemple, en les chauffant dans un four afin que la colle, présente sur chaque attache 91, se polymérise ce qui a pour effet de solidariser chaque attache 91 dans son centre 69 associé.

A la fin de l'étape 13, on obtient donc un substrat 53 dont la pièce 51 de chaque motif 50 est préassemblée. Avantageusement selon l'invention, les dizaines de pièces 51 sont donc toujours manipulables ensemble et peuvent être fournies avec ou sans le support 81 directement sur une ligne de fabrication d'un dispositif, comme, par exemple, un mouvement de pièce d'horlogerie.

La quatrième et dernière étape 11 consiste à exercer un déplacement relatif entre la pièce 51 et le substrat 53 afin de casser les ponts de matière 57. Avantageusement selon l'invention, ce déplacement peut être réalisé en tirant directement sur l'attache 91 ce qui permet le montage final de chaque pièce 51 sans aucune manipulation directe sur le matériau micro-usinable. L'étape 11 peut ainsi être réalisée manuellement à l'aide de brucelles ou à l'aide d'un automate.

Dans l'exemple illustré aux figures 1 et 2, la pièce 51 est une roue d'échappement et l'attache 91, son axe de pivotement. Cependant l'invention ne saurait s'y limiter et, à titre d'exemple, la pièce 51 pourrait être un autre type de rouage, une couronne ou même un ensemble spiral - virole de même que l'attache 91 pourrait être une autre pièce fonctionnelle qu'un axe de pivotement.

Le deuxième mode de réalisation est prévu pour le cas où le matériau micro-usinable comporte des caractéristiques tribologiques insuffisantes pour l'application prévue de la pièce 51. Dans le deuxième mode de réalisation, le procédé 1 comporte les étapes consécutives 3, 5, 7, 9, 13 et 11 comme illustré par un trait double à la figure 7. Les premières étapes 3, 5 restent inchangées par rapport au premier mode de réalisation. Comme visible à la figure 7, au lieu de passer de l'étape 5 à l'étape 13 comme dans le premier mode de réalisation, le deuxième mode de réalisation passe d'abord par les étapes 7 et 9 avant de passer à l'étape 13 ce qui permet avantageusement de déposer un revêtement sur chacune des pièces 51 du substrat 53.

Selon le deuxième mode de réalisation, la troisième étape 7 consiste à monter le substrat 53 gravé sur une base 55 afin de laisser accessibles les faces supérieure et inférieure du substrat 53 dans le but de le préparer à l'étape 9 de dépôt.

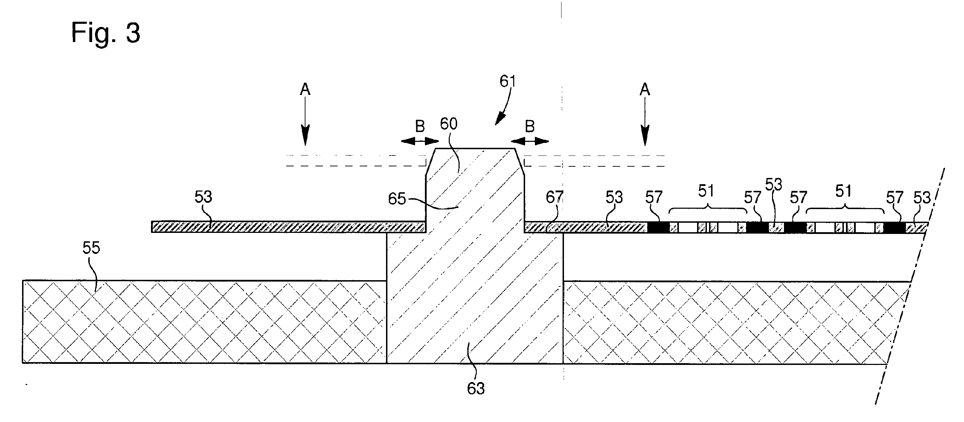

Comme illustré à la figure 3, on peut voir un exemple de base 55 selon le deuxième mode de réalisation. La base 55 est une plaque dont le matériau est capable du supporter les températures de la quatrième étape 9 comme, par exemple, une céramique. Afin de permettre le maintien en hauteur du substrat 53 par rapport à la base 55, cette dernière comporte des axes 61 destinés à coopérer avec les trous 59 réalisés dans le substrat 53 lors de l'étape 5. Pour les mêmes raisons que la base 55, les axes 61 sont préférentiellement en tungstène ou en tantale. L'étape 7 comporte les phases 21 et 23.

Préférentiellement, chaque axe 61 généralement cylindrique comporte une partie basse 63 reliée à une partie haute 65 de plus faible section au moyen d'un épaulement 67. La partie basse 63 est montée sensiblement perpendiculairement dans la base 55 de manière fixe. La partie haute 65 comporte en prolongement une colonne chanfreinée 60 appartenant à des moyens d'alignement cités ci-après.

Dans la première phase 21, comme visible à la figure 3, par rapprochement selon la direction A du substrat 53 par rapport à la base 55, le substrat 53 est guidé selon les directions B à l'aide de moyens d'alignement afin d'orienter fiablement le substrat 53 par rapport à la base 55.

Préférentiellement, les moyens d'alignements sont formés par la colonne chanfreinée 60 coopérant avec un des évidements 59. De manière préférée, le procédé 1 comporte trois moyens d'alignement 60, 59 afin d'améliorer le guidage de la première phase 21.

Dans une deuxième phase 23, en continuant le rapprochement selon la translation A, le substrat 53 glisse contre respectivement chaque partie 65 des axes 61 de la base 55 jusqu'à ce que le substrat 53 bute sensiblement contre l'épaulement 67 de chaque axe 61. Comme visible à la figure 3 à la fin de l'étape 7, le substrat 53 est posé de manière stable et a comme degré de liberté unique la translation A vers le haut.

Dans l'exemple illustré sur les motifs 50 en bas à droite et en haut à gauche de la figure 2, on peut voir une variante aux moyens d'alignement colonne 60 - trou 59. Cette variante est prévue dans le cas où l'espace aux extrémités du substrat 53 ne permet pas de réaliser les trous 59. Selon la variante, deux colonnes 93, 97 sont prévues pour coopérer chacune avec une partie vide d'un motif 50. Préférentiellement, les deux motifs 50 sont le plus éloigné possible l'un de l'autre et chacun est à proximité des extrémités du substrat 53. Dans l'exemple illustré à la figure 2, on peut voir que chaque colonne 93 et 97 de forme sensiblement trigonale coopère avec un motif 50 différent selon une symétrie centrale afin d'améliorer le guidage de l'étape 21. Préférentiellement, la symétrie est réalisée par rapport au centre du substrat 53 et utilise les motifs 50 en haut à gauche et en bas à droite de l'exemple illustré à la figure 1.

De manière préférée, les moyens d'alignement 60, 59, 93, 97 sont situés plus haut verticalement que les axes 61 afin de garantir la consécutivité des phases 21 puis 23.

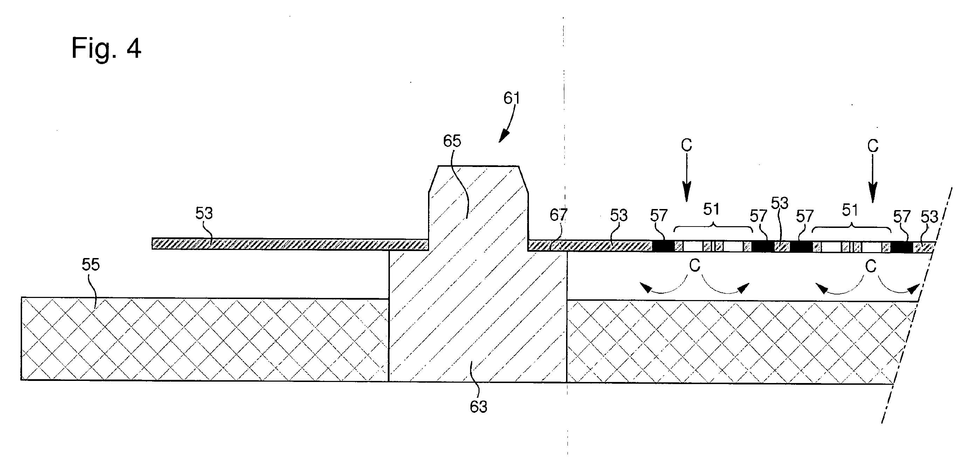

Selon le deuxième mode de réalisation, la quatrième étape 9 consiste à déposer un revêtement sur la surface extérieure de chaque pièce 51. Comme expliqué ci-dessus, le revêtement peut, par exemple, être un allotrope du carbone destiné à améliorer la tribologie de chaque pièce 51, notamment, en diminuant son coefficient de frottement. Comme illustré à la figure 4 par la flèche C, l'étape 9 permet de déposer un revêtement en dessous, sur l'épaisseur et au-dessus du substrat 53 grâce à l'étape 7 de mise en hauteur du substrat 53 et au fait que le substrat 53 ait été gravé dans toute son épaisseur lors de l'étape 5.

A la fin de l'étape 9 le substrat 53 est retiré de la base 55 puis le deuxième mode de réalisation engage la cinquième étape 13 de la même manière que le premier mode de réalisation. A la fin de l'étape 13, on obtient donc un substrat 53 dont la pièce 51 en matériau micro-usinable de chaque motif 50 est revêtue d'un dépôt et préassemblée avec une attache 91. Avantageusement selon l'invention, les dizaines de pièces 51 sont donc toujours manipulables ensemble et peuvent être fournies avec ou sans le support 81 directement sur une ligne de fabrication d'un dispositif, comme, par exemple, un mouvement de pièce d'horlogerie.

La sixième et dernière étape 11 consiste à exercer un déplacement relatif entre la pièce 51 et le substrat 53 afin de casser les ponts de matière 57. Avantageusement selon l'invention, ce déplacement peut être réalisé en tirant directement sur l'attache 91 ce qui permet le montage final de chaque pièce 51 sans aucune manipulation directe sur le matériau micro-usinable et/ou le revêtement déposé. L'étape 11 peut ainsi être réalisée manuellement à l'aide de brucelles ou à l'aide d'un automate. De la même manière que pour le premier mode de réalisation, l'invention selon le deuxième mode de réalisation ne saurait se limiter à une roue d'échappement comme illustré aux figures 1 et 2.

Bien entendu, la présente invention ne se limite pas à l'exemple illustré mais est susceptible de diverses variantes et modifications qui apparaîtront à l'homme de l'art. En particulier, il peut être envisagé un troisième mode de réalisation du procédé 1 qui comporte les étapes consécutives 3, 5, 7, 9 et 11 comme illustré par un trait triple à la figure 7 ce qui permettrait d'obtenir une pièce 51 comportant un revêtement déposé mais dont l'étape 11 serait rendue plus difficile par manque de moyens de préhension tels que l'attache 91 présente dans les premier et deuxième mode de réalisation. L'étape 11 pourrait alors consister à appliquer une contrainte sur les ponts de matière 57 afin qu'ils cèdent dans le but de récupérer ladite pièce.

Les trois variantes montrent que l'invention permet d'offrir une logistique entre chaque étape qui est simplifiée du fait que les pièces 51 ne sont enlevées du substrat 53 que lors de la dernière étape 11. Cela présente, en effet, l'avantage de déplacer des dizaines de pièces 51 entre chaque étape en manipulant uniquement le substrat 53.

## Revendications

1. Procédé de fabrication (1) d'une pièce mécanique (51) comportant les étapes suivantes :
a) se munir (3) d'un substrat (53) en un matériau micro-usinable ;
b) graver (5) par photolithographie, dans la totalité de l'épaisseur dudit substrat, un motif (50) comportant ladite pièce ;
**caractérisé en ce qu'**il comporte en outre les étapes suivantes :
c) assembler (13) une attache (91) sur ladite pièce afin que cette dernière (51) soit prête à être montée sans avoir à toucher la partie en matériau micro-usinable.
d) libérer (11) la pièce (51) du substrat (53) afin de la monter dans un dispositif.

2. Procédé selon la revendication 1, **caractérisé en ce que** l'étape c) comporte les étapes suivantes :
e) monter (25) sur un support (81) munis de fourchettes (87) ledit substrat (53) afin que les fourchettes (87) coopèrent avec ladite pièce ;
f) assembler (27) l'attache (91) sur la pièce (51) montée contre le support (81).

3. Procédé selon la revendication 2, **caractérisé en ce que** l'étape e) comporte les étapes suivantes :
g) guider (E) le substrat (53) par rapport audit support à l'aide de moyens d'alignement (80, 59, 93, 97, 50) afin d'orienter fiablement ledit substrat ;
h) glisser le substrat (53) et la pièce (51) contre respectivement au moins un axe (85) et les fourchettes (87) solidaires du support (81) jusqu'à buter contre un épaulement (88) respectivement dudit au moins un axe et desdites fourchettes afin de préparer le montage de l'attache (91).

4. Procédé selon la revendication 3, **caractérisé en ce que** les moyens d'alignement (80, 59, 93, 97, 50) sont situés plus haut que ledit au moins un axe et lesdites fourchettes afin de garantir la consécutivité des étapes g) puis h).

5. Procédé selon la revendication 3 ou 4, **caractérisé en ce que** le support (81) comporte plusieurs moyens d'alignement (80, 59, 93, 97, 50) afin d'améliorer le guidage de l'étape g).

6. Procédé selon l'une des revendications 3 à 5, **caractérisé en ce que** les moyens d'alignement comportent au moins une colonne (80, 93, 97) solidaire du support (81) et destinée à coopérer avec un évidement (59, 50) réalisé dans le substrat (53) lors de l'étape b).

7. Procédé selon la revendication 6, **caractérisé en ce que** chaque évidement (59) est réalisé à proximité des extrémités du substrat (53).

8. Procédé selon la revendication 6, **caractérisé en ce que** chaque évidement correspond à un espace vide du motif (50).

9. Procédé selon l'une des revendications précédentes, **caractérisé en ce qu'**il comprend, en outre, entre les étapes b) et c), les étapes suivantes
i) monter (7) sur une base (55) ledit substrat gravé afin de laisser accessibles les faces supérieure et inférieure de ce dernier ;
j) déposer (9, C) un revêtement sur la surface extérieure de ladite pièce de meilleure qualité tribologique que ledit matériau micro-usinable.

10. Procédé selon la revendication 9, **caractérisé en ce que** l'étape h) comporte les étapes suivantes :
k) guider (21, B) le substrat (53) par rapport à ladite base à l'aide de moyens d'alignement (60, 59, 93, 97) afin d'orienter fiablement ledit substrat ;
l) glisser (23, A) le substrat (53) contre au moins un axe (61) solidaire du support (55) jusqu'à buter contre un épaulement (67) dudit au moins un axe réalisé à distance dudit support afin de maintenir en hauteur le substrat (53) par rapport audit support.

11. Procédé selon la revendication 10, **caractérisé en ce que** les moyens d'alignement (60, 59, 93, 97) sont situés plus haut que ledit au moins un axe afin de garantir la consécutivité des étapes k) puis l).

12. Procédé selon la revendication 10 ou 11, **caractérisé en ce que** le support (55) comporte plusieurs moyens d'alignement (60, 59, 93, 97, 50) afin d'améliorer le guidage de l'étape k).

13. Procédé selon l'une des revendications 10 à 12, **caractérisé en ce que** les moyens d'alignement comportent au moins une colonne (60, 93, 97, 50) solidaire du support (55) destinée à coopérer avec un évidement (59, 50) réalisé dans le substrat (53) lors de l'étape b).

14. Procédé selon la revendication 13, **caractérisé en ce que** chaque évidement (59) est réalisé à proximité des extrémités du substrat (53).

15. Procédé selon la revendication 13, **caractérisé en ce que** chaque évidement correspond à un espace vide du motif (50).

16. Procédé selon l'une des revendications précédentes, **caractérisé en ce que**, lors de l'étape b), au moins un pont de matière (57) est gravé dans le motif (50) afin de maintenir solidaire la pièce (51) avec le substrat (53).

17. Procédé selon la revendication 16, **caractérisé en ce que** ledit au moins un pont de matière comporte une section rétrécie à l'extrémité reliée au motif de ladite pièce permettant de créer une zone de faiblesse apte à faciliter l'étape e).

18. Procédé la revendication 16 ou 17, **caractérisé en ce que** l'étape d) est réalisée par déplacement relatif entre la pièce (51) et le substrat (53) afin de casser ledit au moins un pont de matière (57).

19. Procédé selon l'une des revendications précédentes, **caractérisé en ce que** le substrat (53) est aminci entre l'étape a) et b) afin d'adapter l'épaisseur finale de la pièce (51).

20. procédé selon l'une des revendications précédentes, **caractérisé en ce que** plusieurs pièces (51) sont fabriquées à partir du même substrat (53).

21. Procédé selon l'une des revendications précédentes, **caractérisé en ce que** l'étape b) comporte les étapes suivantes :
- structurer (15) sur le substrat (53) un masque de protection de forme correspondante à ladite pièce ;
- attaquer (17) par gravure anisotropique l'ensemble substrat - masque ;
- retirer (19) ledit masque de protection.

22. Procédé selon la revendication 21, **caractérisé en ce que** ledit masque de protection est réalisé à l'aide d'une résine photosensible.

23. Procédé selon l'une des revendications précédentes, **caractérisé en ce que** ledit matériau micro-usinable étant choisi parmi le groupe comprenant du silicium cristallin, de la silice cristalline et de l'alumine cristalline.

24. Procédé selon l'une des revendications précédentes, **caractérisé en ce que** le dispositif est une pièce d'horlogerie.

## Patentansprüche

1. Verfahren (1) zum Herstellen eines mechanischen Stücks (51), welches Verfahren folgende Schritte umfasst:
a) Bereitstellen (3) eines Substrats (53) aus einem mikrobearbeitbaren Werkstoff;
b) Gravieren (5) eines das besagte Stück umfassenden Motivs (50) mittels Photolithographie in die gesamte Dicke des Substrats;
**dadurch gekennzeichnet, dass** es zudem folgende Schritte umfasst:
c) Montieren (13) eines Ansatzes (91) auf das Stück, damit dieses Letztere (51) bereit ist, montiert zu werden, ohne den Teil aus mikrobearbeitbarem Werkstoff berühren zu müssen;
d) Befreien (11) des Stücks (51) vom Substrat (53), um es in eine Vorrichtung einzubauen.

2. Verfahren nach Anspruch 1, **dadurch gekennzeichnet, dass** der Schritt c) folgende Schritte umfasst:
e) Montieren (25) des Substrats (53) auf einen mit Gabeln (87) versehenen Träger (81), derart, dass die Gabeln (87) mit dem Stück zusammenarbeiten;
f) Montieren (27) des Ansatzes (91) auf das an den Träger (81) angefügte Stück (51).

3. Verfahren nach Anspruch 2, **dadurch gekennzeichnet, dass** der Schritt e) folgende Schritte umfasst:
g) Führen (E) des Substrats (53) im Verhältnis zum Träger mit Hilfe von Ausrichtungsmitteln (80, 59, 93, 97, 50), um dieses Substrat zuverlässig zu orientieren;
h) Schieben des Substrats (53) und des Stücks (51) gegen wenigstens eine Welle (85) bzw. die Gabeln (87), die mit dem Träger (81) fest verbunden sind, bis sie gegen eine Schulter (88) der wenigstens einen Welle bzw. der Gabeln stossen, um die Montage des Ansatzes (91) vorzubereiten.

4. Verfahren nach Anspruch 3, **dadurch gekennzeichnet, dass** die Ausrichtungsmittel (80, 59, 93, 97, 50) höher liegen als die wenigstens eine Welle und die Gabeln, um die Aufeinanderfolge der Schritte g) und dann h) zu gewährleisten.

5. Verfahren nach Anspruch 3 oder 4, **dadurch gekennzeichnet, dass** der Träger (81) mehrere Ausrichtungsmittel (80, 59, 93, 97, 50) umfasst, um die Führung des Schritts g) zu verbessern.

6. Verfahren nach einem der Ansprüche 3 bis 5, **dadurch gekennzeichnet, dass** die Ausrichtungsmittel wenigstens eine Säule (80, 93, 97) umfassen, die mit dem Träger (81) fest verbunden ist und dazu bestimmt ist, mit einer Aussparung (59, 50) zusammenzuarbeiten, die während des Schritts b) im Substrat (53) ausgeführt wird.

7. Verfahren nach Anspruch 6, **dadurch gekennzeichnet, dass** jede Aussparung (59) in der Nähe der äussersten Enden des Substrats (53) ausgeführt ist.

8. Verfahren nach Anspruch 6, **dadurch gekennzeichnet, dass** jede Aussparung einem freien Raum des Motivs (50) entspricht.

9. Verfahren nach einem der vorhergehenden Ansprüche, **dadurch gekennzeichnet, dass** es zudem zwischen den Schritten b) und c) folgende Schritte umfasst:
i) Montieren (7) des gravierten Substrats auf eine Basis (55), derart, dass die obere und die untere Fläche des Substrats zugänglich bleiben;
j) Aufbringen (9, C) eines Überzugs auf die äussere Fläche des Stücks, welcher Überzug eine bessere Tribologie-Eigenschaft aufweist als der mikrobearbeitbare Werkstoff.

10. Verfahren nach Anspruch 9, **dadurch gekennzeichnet, dass** der Schritt h) folgende Schritte umfasst:
k) Führen (21, B) des Substrats (53) im Verhältnis zur Basis mit Hilfe von Ausrichtungsmitteln (60, 59, 93, 97), um dieses Substrat zuverlässig zu orientieren;
l) Schieben (23, A) des Substrats (53) gegen wenigstens eine mit dem Träger (55) fest verbundene Welle (61), bis es gegen eine Schulter (67) der wenigstens einen Welle stösst, welche Schulter in Abstand zum Träger realisiert ist, um das Substrat (53) im Verhältnis zum Träger in der Höhe zu halten.

11. Verfahren nach Anspruch 10, **dadurch gekennzeichnet, dass** die Ausrichtungsmittel (60, 59, 93, 97) höher liegen als die wenigstens eine Welle, um die Aufeinanderfolge der Schritte k) und dann l) zu gewährleisten.

12. Verfahren nach Anspruch 10 oder 11, **dadurch gekennzeichnet, dass** der Träger (55) mehrere Ausrichtungsmittel (60, 59, 93, 97, 50) umfasst, um die Führung des Schritts k) zu verbessern.

13. Verfahren nach einem der Ansprüche 10 bis 12, **dadurch gekennzeichnet, dass** die Ausrichtungsmittel wenigstens eine mit dem Träger (55) fest verbundene Säule (60, 93, 97, 50) umfassen, die dazu bestimmt ist, mit einer Aussparung (59, 50) zusammenzuarbeiten, die während des Schritts b) im Substrat (53) ausgeführt wird.

14. Verfahren nach Anspruch 13, **dadurch gekennzeichnet, dass** jede Aussparung (59) in der Nähe der äussersten Enden des Substrats (53) ausgeführt ist.

15. Verfahren nach Anspruch 13, **dadurch gekennzeichnet, dass** jede Aussparung einem freien Raum des Motivs (50) entspricht.

16. Verfahren nach einem der vorhergehenden Ansprüche, **dadurch gekennzeichnet, dass** während des Schritts b) wenigstens eine Werkstoffbrücke (57) ins Motiv (50) graviert wird, um das Stück (51) mit dem Substrat (53) fest verbunden zu halten.

17. Verfahren nach Anspruch 16, **dadurch gekennzeichnet, dass** die wenigstens eine Werkstoffbrücke an dem mit dem Motiv des Stücks verbundenen Ende einen verengten Abschnitt aufweist, der ermöglicht, eine Schwachzone zu schaffen, die für die Erleichterung des Schritts e) geeignet ist.

18. Verfahren nach Anspruch 16 oder 17, **dadurch gekennzeichnet, dass** der Schritt d) durch eine relative Verlagerung zwischen dem Stück (51) und dem Substrat (53) durchgeführt wird, um die wenigstens eine Werkstoffbrücke (57) zu zerbrechen.

19. Verfahren nach einem der vorhergehenden Ansprüche, **dadurch gekennzeichnet, dass** das Substrat (53) zwischen dem Schritt a) und b) dünner gemacht wird, um die Schlussdicke des Stücks (51) passend zu machen.

20. Verfahren nach einem der vorhergehenden Ansprüche, **dadurch gekennzeichnet, dass** mehrere Stücke (51) ausgehend von demselben Substrat (53) hergestellt werden.

21. Verfahren nach einem der vorhergehenden Ansprüche, **dadurch gekennzeichnet, dass** der Schritt b) folgende Schritte umfasst:
- Strukturieren (15) einer Schutzmaske in einer dem Stück entsprechenden Form auf dem Substrat (53);
- Angreifen (17) der Substrat-Masken-Einheit durch anisotrope Gravierung;
- Entfernen (19) der Schutzmaske.

22. Verfahren nach Anspruch 21, **dadurch gekennzeichnet, dass** die Schutzmaske mit Hilfe eines lichtempfindlichen Harzes realisiert wird.

23. Verfahren nach einem der vorhergehenden Ansprüche, **dadurch gekennzeichnet, dass** der mikrobearbeitbare Werkstoff unter der kristallines Silizium, kristallines Siliziumoxid und kristallines Aluminiumoxid umfassenden Gruppe gewählt wird.

24. Verfahren nach einem der vorhergehenden Ansprüche, **dadurch gekennzeichnet, dass** die Vorrichtung ein Zeitmessgerät ist.

## Claims

1. Method (1) of manufacturing a mechanical part (51) including the following steps:
a) providing (3) a substrate (53) made of micro-machinable material;
b) etching (5), with help of photolithography, a pattern (50) that includes said part through said entire substrate;
**characterized in that** it further includes the following steps:
c) assembling (13) a clip (91) on said part so that said part (51) is ready to be mounted without the portion made of micro-machinable material having to be touched;
d) releasing (11) the part (51) from the substrate (53) so as to mount said part in a device.

2. Method according to claim 1, **characterized in that** step c) includes the following steps:
e) mounting (25) said substrate (53) on a support (81) fitted with forks (87), so that the forks (87) cooperate with said part;
f) assembling (27) the clip (91) on the part (51) mounted against the support (81).

3. Method according to claim 2, **characterized in that** step e) includes the following steps:
g) guiding (E) the substrate (53) relative to said support using alignment means (80, 59, 93, 97, 50) so as to orient said substrate reliably;
h) sliding the substrate (53) and the part (51) respectively against at least one pin (85) and the forks (87) secured to the support (81) so as to abut against a shoulder (88) of said at least one pin and said forks respectively, in order to prepare for assembly of the clip (91).

4. Method according to claim 3, **characterized in that** the alignment means (80, 59, 93, 97, 50) are located higher than said at least one pin and said forks so as to guarantee the consecutiveness of steps g) then h).

5. Method according to claim 3 or 4, **characterized in that** the support (81) includes several alignment means (80, 59, 93, 97, 50) so as to improve the guiding in step g).

6. Method according to any of claims 3 to 5, **characterized in that** the alignment means include at least one column (80, 93, 97) secured to the support (81) for cooperating with a recess (59, 50) made in the substrate (53) in step b).

7. Method according to claim 6, **characterized in that** each recess (59) is made in proximity to the ends of the substrate (53).

8. Method according to claim 6, **characterized in that** each recess corresponds to an empty space in the pattern (50).

9. Method according to any of the preceding claims, **characterized in that** it further includes, between steps b) and c), the following steps:
i) mounting (7) said etched substrate on a base (55) so as to leave the top and bottom surfaces thereof accessible;
j) depositing (9, C) a coating of better tribological quality than said micro-machinable material on the external surface of said part.

10. Method according to claim 9, **characterized in that** step h) includes the following steps:
k) guiding (21, B) the substrate (53) relative to said base using alignment means (60, 59, 93, 97) so as to orient said substrate reliably;
l) sliding (23, A) the substrate (53) against at least one pin (61) secured to the support (55) until the substrate abuts against a shoulder (67) of said at least one pin made at a distance from said support so as to keep the substrate (53) high relative to said support.

11. Method according to claim 10, **characterized in that** the alignment means (60, 59, 93, 97) are located higher than said at least one pin so as to guarantee the consecutiveness of steps k) then l).

12. Method according to claim 10 or 11, **characterized in that** the support (55) has several alignment means (60, 59, 93, 97, 50) for improving the guiding in step k).

13. Method according to any of claims 10 to 12, **characterized in that** the alignment means include at least one column (60, 93, 97, 50) secured to the support (55) for cooperating with a recess (59, 50) made in the substrate (53) in step b).

14. Method according to claim 13, **characterized in that** each recess (59) is made in proximity to the ends of the substrate (53).

15. Method according to claim 13, **characterized in that** each recess corresponds to an empty space in the pattern (50).

16. Method according to any of the preceding claims, **characterized in that**, during step b), at least one bridge of material (57) is etched in the pattern (50) so as to keep the part (51) secured to the substrate (53).

17. Method according to claim 16, **characterized in that** said at least one bridge of material includes a narrow portion at the end connected to the pattern of said part for creating a zone of weakness that can facilitate step e).

18. Method according to claim 16 or 17, **characterized in that** step d) is achieved by the relative movement between the part (51) and the substrate (53) in order to break said at least one bridge of material (57).

19. Method according to any of the preceding claims, **characterized in that** the substrate (53) is thinned between step a) and b) so as to adapt the final thickness of the part (51).

20. Method according to any of the preceding claims, **characterized in that** several parts (51) are manufactured from the same substrate (53).

21. Method according to any of the preceding claims, **characterized in that** step b) includes the following steps:
- structuring (15) a protective mask in a shape matching said part on the substrate (53);
- anisotropic etching (17) the substrate-mask assembly;
- removing (19) said protective mask.

22. Method according to claim 21, **characterized in that** said protective mask is made using a photosensitive resin.

23. Method according to any of the preceding claims, **characterized in that** said micro-machinable material is chosen from among the group comprising crystalline silicon, crystalline silica and crystalline alumina.

24. Method according to any of the preceding claims, **characterized in that** the device is a timepiece.
